# EUROPEAN PATENT SPECIFICATION

(11) **EP 3 872 251 B1**
(45) Date of publication and mention of the grant of the patent: **07.06.2023**
(21) Application number: 19936010.8
(22) Date of filing: 03.07.2019
(51) Int. Cl.: D06F 34/30, D06F 34/32, H01H 3/50, H01H 9/16

(54) **KNOB STRUCTURE FOR WASHING MACHINE AND WASHING MACHINE**
BEDIENKNOPFSTRUKTUR FÜR EINE WASCHMASCHINE UND WASCHMASCHINE
STRUCTURE DE BOUTON DESTINÉE À UN LAVE-LINGE ET LAVE-LINGE

(43) Date of publication of application: 01.09.2021
(73) Proprietor: Whirlpool China Co., Ltd., Industrial Development Zone Hefei Anhui 230088 (CN)
(72) Inventor: HUANG, Yukai, Hefei, Anhui 230088 (CN); WANG, Hongqiang, Hefei, Anhui 230088 (CN); HUA, Fanmeng, Hefei, Anhui 230088 (CN); MAO, Yujin, Hefei, Anhui 230088 (CN)
(74) Representative: Petculescu, Ana-Maria
(86) International application number: PCT/CN2019/094608
(87) International publication number: WO 2021/000300

(56) References cited:
- EP-A1- 3 168 357
- CN-U- 203 895 334

## Description

### FIELD

The invention relates to the technical field of washing machines, in particular to a knob structure for a washing machine and a washing machine.

### BACKGROUND

At present, most of the control panels of washing machines are equipped with knobs. The knob cooperates with multiple buttons to realize the setting and switching of program functions such as washing mode or washing time. The existing washing machines have separately distributed knob buttons and have no function of displaying the position of rotation grade, which are very inconvenient to operate and affect user experience.

EP 3168357A1 discloses laundry treatment appliance (2), comprising a user interface (62), said user interface (62) comprising an assembly (66), said assembly (66) comprising at least one fixed element (68,72,80), at least one rotary element (76, 88), and a display (68).

CN 203 895 334 U discloses an integrated function selector and belongs to the technical field of electronic devices. The integrated function selector comprises an encoder and a plurality of function keys, a PCB is disposed in an encoder body, the PCB is electrically connected with an external PLC, a plurality of function selecting switches are disposed on the PCB, and the function keys and the function selecting switches are electrically connected. On the basis of an existing encoder, part of the function keys are integrated into the internal so that the structure is more compact and efficient; after the finished product is manufactured, the appearance lets a person have a new experience, and more function selections are provided; and, in addition, the encoder and the function keys are assembled types, can be detached individually and are very convenient to maintain and replace.

CN204434991U discloses a rotary knob for a household appliance and a washing machine with the rotary knob. The rotary knob for the household appliance comprises a rotating component and a display device, wherein the rotating component can be rotated to select different functions of the household appliance, the display device is arranged in the rotating component in a sleeving mode and cannot rotate along with the rotating component, meanwhile, and the display device is electrically connected with a circuit device used for the household appliance to display working information of the household appliance. According to the rotary knob for the household appliance and the washing machine with the rotary knob, the rotary knob can not only select the operation modes but also display information of the setting state and the working state through the display device, the display device and the rotating component are integrated as a whole, the structure is more compact, meanwhile, the rotary knob is convenient to use for a user, and the user experience is improved; in addition, the rotary knob further has a selection function through further comprising a switch and a triggering device.

US20050205395 discloses a rotary selector as display console for contact-free on and off switching as well as for switching of the automatic control of a number of different cycles of electrically operated domestic appliances, such as washing machines, dryers, dishwashers or comparable units. To simplify its assembly and maintenance the inventive rotary selector (1) has mutually communicating catch devices and a plate arranged at a distance thereto with a rotary field sensor according to Hall technology, whereby spring-loaded ball lockings enable defined and switchable rotation of an operating element (2) with magnetic device in ranges up to 360°, and whereby angle-dependent variables for control of a wide range of cycles are generated in a known manner in the rotary field sensor.

CN208733340U discloses a button structure, including encoder and main circuit board, the encoder sets up on washing machine's main circuit board, with main circuit board electric connection stillincludes and presses key assembly, set up inside the encoder according to key assembly to press key assembly also with main circuit board electric connection, the direction that can follow center pinperpendicular to main circuit board according to key assembly removes. The button structure will rotate, press and show function collection in an organic whole, rotating assembly through rotating on the encoder can carry out the selection of corresponding washing procedure and washing parameter, but through the setting and the affirmation of pressing key assembly control switch machine and other functions, it can show that current washing parameter is and have instruction function to go up the display module assembly that sets up according to key assembly simultaneously, compared with the prior art, it feels to promote user's body, the pressure of circuit board has been reduced, simple structure, and the present is favorable for popularization and application.

### SUMMARY

An object of the present invention is to provide a knob structure for a washing machine and a washing machine. The knob structure for a washing machine and the washing machine can solve the deficiencies in the prior art, and has the function of displaying the position of rotation grade, therefor the operation is simple and convenient.

The present invention is defined in the independent claim 1, and the preferable features according to the present invention are defined in the dependent claims. Any embodiment in the present disclosure that does not fall within the scope of the present invention should be regarded as an example for understanding the present invention.

In order to achieve the above object, the present invention adopts the following technical solutions:
A knob structure for a washing machine includes a rotating assembly, a display screen assembly, a pressing assembly, an incremental code plate, and a PCBA (printed circuit board assembly), wherein:
the rotating assembly can transmit a pressing force to the pressing assembly, the rotating assembly includes a knob rotation base, a fixed body, and a knob decoration ring mounted above the top of the knob rotation base; a first accommodating groove is provided at an upper end of the knob rotation base, a second accommodating groove is provided in a middle section of the knob rotation base, and a third accommodating groove is provided at a lower end of the knob rotation base; and several uniformly distributed concave-convex grooves are provided on an inner peripheral wall of the second accommodating groove;
the display screen assembly is arranged in the rotating assembly and is electrically connected to the PCBA, the display screen assembly is used to display various commands of the washing machine, the display screen assembly includes a display base, a display module mounted on the top of the display base and electrically connected to the PCBA, and a glass lens pasted on the top of the display module; an upper end of the display base is placed in the first accommodating groove; a lower end of the fixed body is located below a bottom of the second accommodating groove, an upper-middle end of the fixed body passes through the second accommodating groove and is fixedly connected to the upper end of the display base, and a gap is formed between the knob decoration ring and the display screen assembly;
the incremental code plate is arranged inside the rotating assembly and is electrically connected to the PCBA, the incremental code plate feeds back different electrical signals to the PCBA according to a change in the rotation angle of the rotating assembly, and the PCBA processes the electrical signal, then call a corresponding program and send a corresponding command to the display screen assembly; and
the PCBA is located under the pressing assembly, a switch button of the pressing assembly is electrically connected to the PCBA, and when the pressing assembly is descended by an external force, the switch button is turned on and the command on the display screen assembly is determined;
the pressing assembly includes a knob fixing support and the switch button; the knob fixing support includes a supporting plate, a first supporting groove mounted above a middle of the supporting plate, a second supporting groove mounted above an outer periphery of the supporting plate, and a third supporting groove mounted below the supporting plate; the switch button is mounted in the first supporting groove and is electrically connected to the PCBA; the PCBA is mounted in the third supporting groove; the supporting plate is further provided with a rotating sound generator and several positioning columns thereabove; the positioning columns are located between the first supporting groove and the second supporting groove; a return spring is sleeved on the positioning column; a middle-lower end of the knob rotation base is embedded in the second supporting groove; a middle-lower end of the display base passes through the second accommodating groove, extends into the first supporting groove to be connected therewith.

Further, the knob structure further includes a waterproof assembly; the waterproof assembly includes a sealing ring A disposed between the display base and the first accommodating groove, a sealing ring B disposed between the first accommodating groove and the second supporting groove, a bottom cover mounted at a bottom opening of the third supporting groove, and a sealing ring C disposed between the third supporting groove and the bottom cover.

Preferably, the first supporting groove is provided with a claw and a guide groove.

Further, the knob structure further includes a rotating sound generator, a mounting seat for the rotating sound generator is arranged along the outer periphery of the first supporting groove; the rotating sound generator includes a steel ball and a spring; the mounting base for the rotating sound generator is provided with a mounting groove on which a cover plate is disposed and in which the steel ball and the spring are mounted sequentially from the outside to the inside; the spring has an inner end that is in contact with an outer peripheral wall of the first supporting groove and an outer end that is in contact with the steel ball; and an outer end part of the steel ball protrudes from an outer opening of the mounting groove and adapts to the concave-convex groove.

Further, the incremental encoder includes a metal conductive sheet A, a metal conductive sheet B, a metal conductive sheet C, and a metal conductive sheet D; the metal conductive sheet A is mounted at the bottom of the second accommodating groove; the metal conductive sheet B, the metal conductive sheet C, and the metal conductive sheet D are mounted at the lower end of the fixed body; a plurality of contacts are uniformly arranged on the periphery of the upper end surface of the metal conductive sheet A at a certain angle; pins of the metal conductive sheet B, the metal conductive sheet C, and the metal conductive sheet D are electrically connected to the PCBA; and the metal conductive sheet B, the metal conductive sheet C, and the metal conductive sheet D are each provided with a contact pin located outside the fixed body.

Further, a silica gel switch is mounted on the switch button; and a switch bracket for fixing the switch button and the silica gel switch is further mounted on the supporting plate.

A washing machine includes a control panel, the control panel being provided with a touch screen at the front thereof and a touch display control system at the back thereof, the control panel being further provided with the knob structure above mentioned; the touch display control system being electrically connected to the PCBA.

The present invention also relates to a washing machine, including a control panel that is provided with a touch screen at the front thereof and a touch display control system at the back thereof, the control panel being further provided with the knob structure described above; the touch display control system being electrically connected to the PCBA.

It can be seen from the above technical solutions that the knob structure of the present invention has the functions of rotating and pressing. Rotation of the knob structure allows selection of different programs, and the program content can be displayed in real time on the touch screen and display screen assembly. The program is selected by pressing the knob structure or directly touching the touch screen or the touch display control system, which improves the space utilization of the control panel of the washing machine and provides simple and convenient operation.

### BRIEF DESCRIPTION OF THE DRAWINGS

Fig. 1 is an exploded structural schematic view of the knob structure in the present invention;
Fig. 2 is a longitudinal sectional view of the knob structure in the present invention;
Fig. 3 is a schematic view of the assembled structure of the display base and the knob fixing support in the present invention;
Fig. 4 is a schematic view of the assembled structure of the knob rotation base (not including the knob decoration ring), the display base, and the fixed body in the present invention; Fig. 4 and Fig. 2 have different cutting positions;
Fig. 5 is a structural schematic view of the fixed body in the present invention;
Fig. 6 is a structural schematic view of the metal conductive sheets B, C, and D in the present invention;
Fig. 7 is a schematic view of assembly of the knob rotation base and the metal conductive sheet A in the present invention;
Fig. 8 is a structural schematic view of the knob rotation base in the present invention;
Fig. 9 is a longitudinal sectional view of the knob rotation base in the present invention;
Fig. 10 is a structural schematic view of the knob fixing support in the present invention;
Fig. 11 is a longitudinal sectional view of the knob fixing support in the present invention;
Fig. 12 is a structural schematic view of the washing machine in the present invention;
Fig. 13 is a schematic view of assembly of the control panel, the touch display control system, and the knob structure in the present invention;
Fig. 14 is a schematic diagram of assembly of the touch display control system and the knob structure in the present invention.

In the drawings:
1: Washing machine, 1-1: control panel, 1-2: touch display control system, 1-3: knob structure, 1-4: touch screen, 10: rotating assembly, 101: knob decoration ring, 102: knob rotation base, 102-1: first accommodating groove, 102-2: second accommodating groove, 102-3: third accommodating groove, 102-4: concave-convex groove, 103: metal conductive sheet A, 103-Z: contact Z of metal conductive sheet A, 104: fixed body, 104-1: contact pin, 104-B: metal conductive sheet B, 104-C: metal conductive sheet C, 20: display screen assembly, 201: glass lens, 202: display module, 203: display base, 30: pressing assembly, 301: knob fixing support, 301-1: supporting plate, 301-2: first supporting groove, 301-3: second supporting groove, 301-4: third supporting groove, 302: switch button, 303: silica gel switch, 304: switch bracket, 305: return spring, 40: waterproof assembly, 401: sealing ring A, 402: sealing ring B, 403: sealing ring C, 404: bottom cover, 50: rotating sound generator, 501: spring, 502: steel ball, 503: cover plate, 601: PCBA, KZ: claw, DXC: guide groove, Y: positioning column.

### DETAILED DESCRIPTION

The present invention will be further explained below in reference with the drawings.

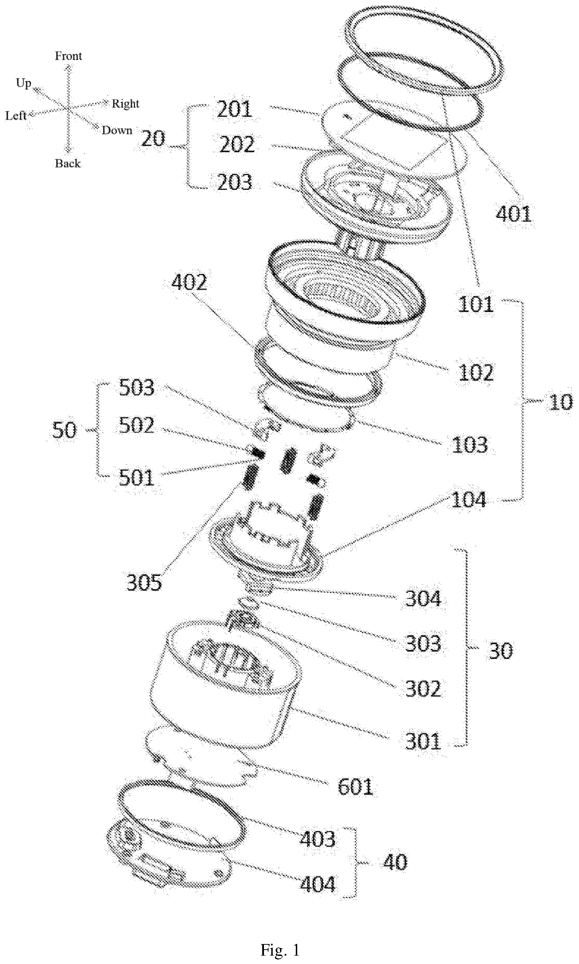

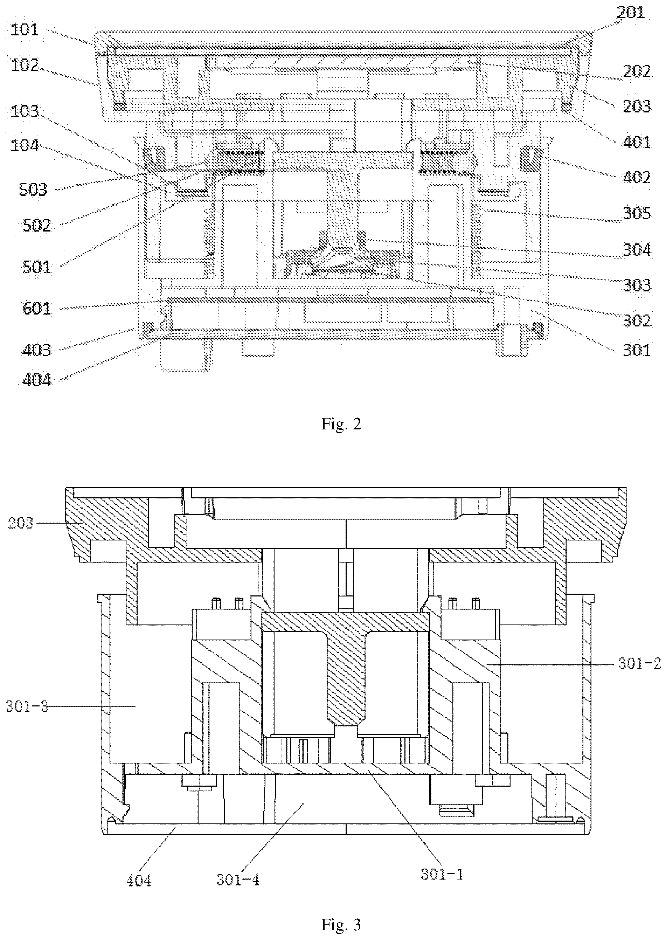

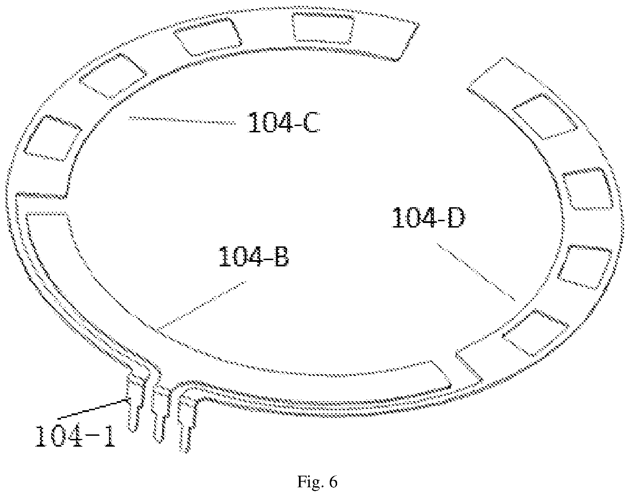

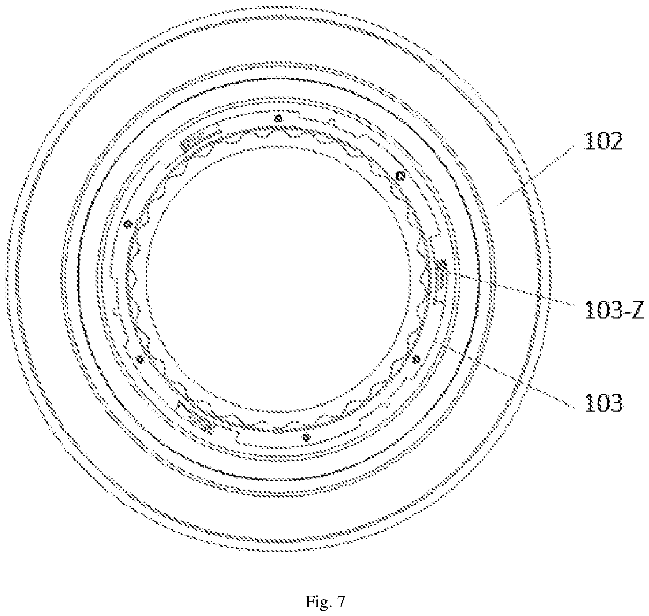

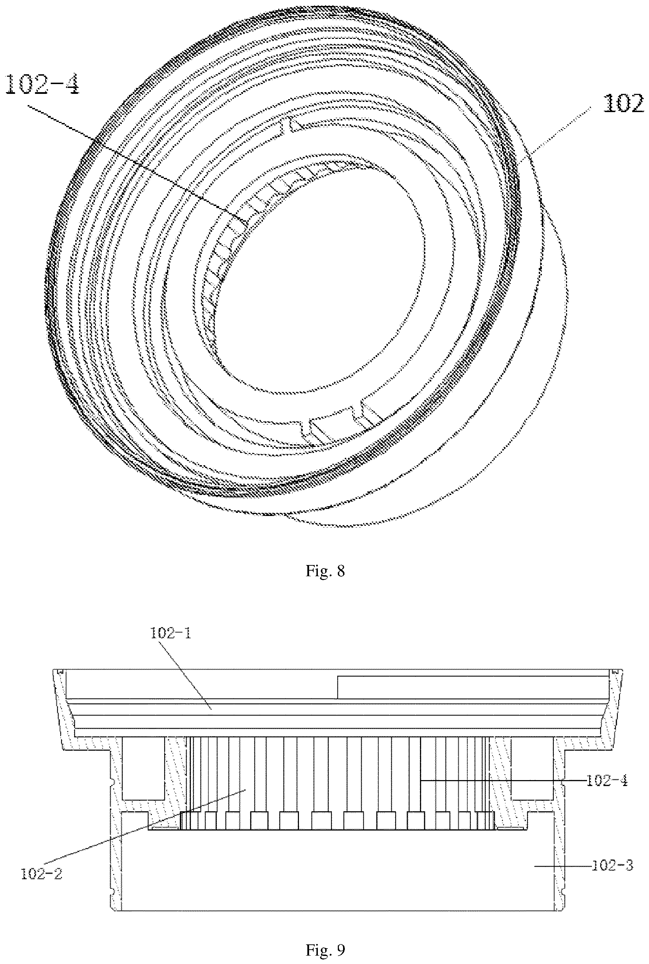

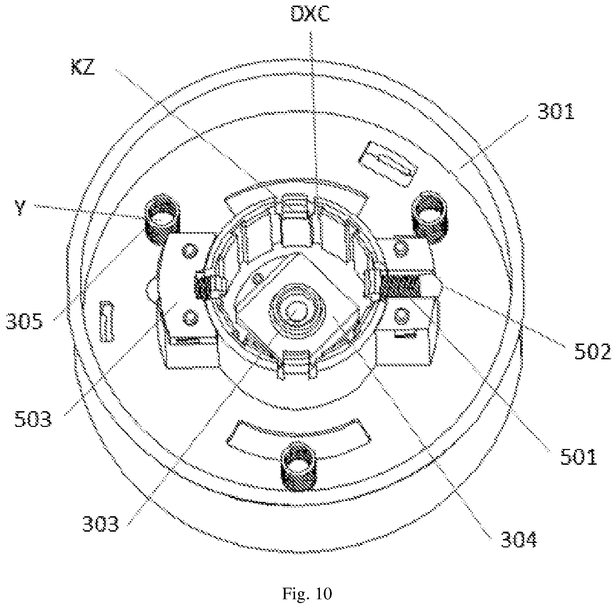

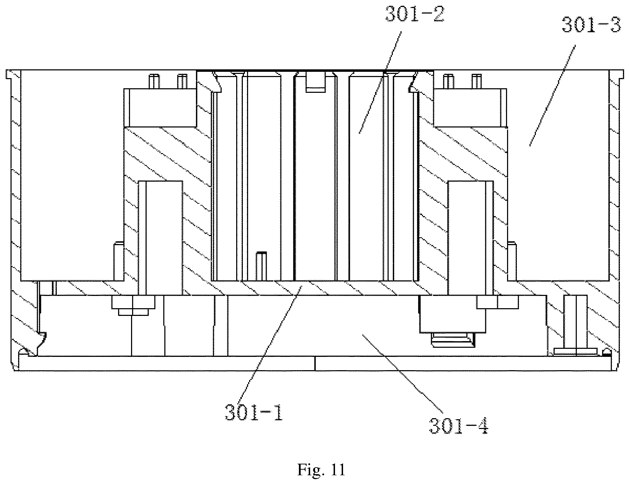

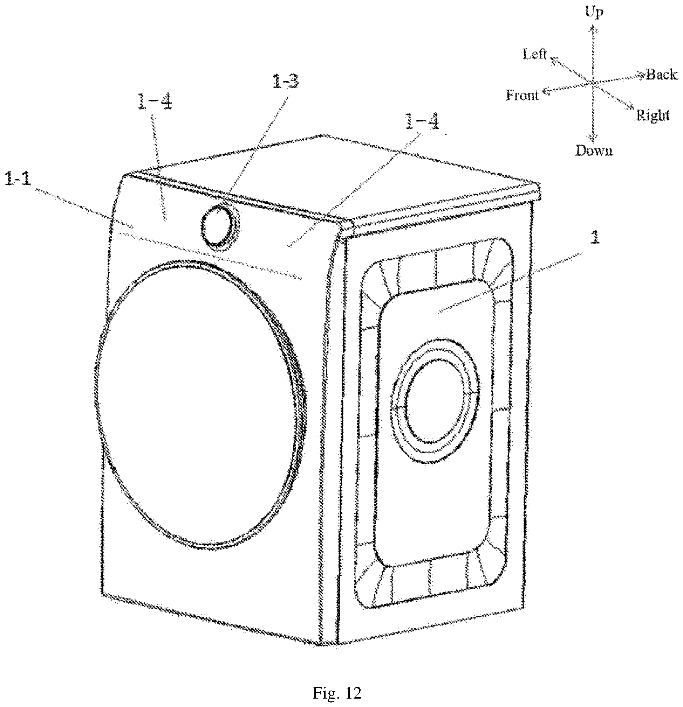

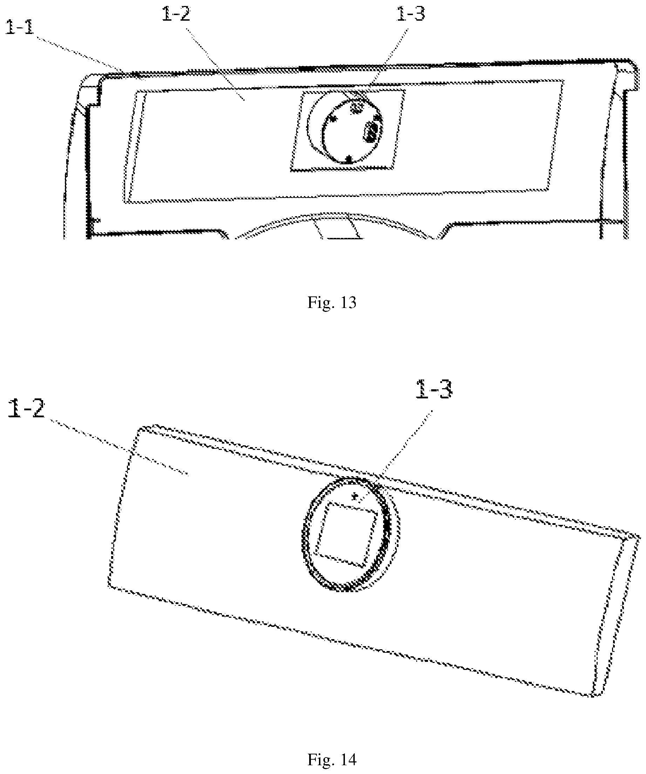

A knob structure for a washing machine, as shown in Figs. 1 to 14, includes a rotating assembly 10, a display screen assembly 20, a pressing assembly 30, and a PCBA 601.

The rotating assembly 10 can transmit a pressing force to the pressing assembly 30, that is, the rotating assembly 10 can not only rotate on the washing machine, but also transmit the pressing force to the pressing assembly 30, so that the operator can control compression of the pressing assembly 30 merely by manipulating the rotating assembly 10. Specifically, the rotating assembly 10 may be supported on the pressing assembly 30. When the rotating assembly 10 is pressed down, the pressing assembly 30 is pushed to be compressed.

The display screen assembly 20 is disposed in the rotating assembly 10 and is electrically connected to the PCBA 601. The display screen assembly 20 is used to display various commands of the washing machine. It can be seen that the operator can clearly acknowledge the command of the washing machine through the rotating assembly 10, without addition of other display components to the washing machine to help manipulation of the operator. Definitely, the display screen assembly 20 does not rotate with the rotation of the rotating assembly 10.

The incremental code plate is disposed inside the rotating assembly 10 and is electrically connected to the PCBA 601. The incremental code plate feeds back different electrical signals to the PCBA 601 according to a change of the rotation angle of the rotating assembly 10. After the PCBA 601 processes the electrical signal, it sends a corresponding command to the display screen assembly 20. First, the incremental code plate can measure the rotation angle and direction of the rotating assembly 10. Then, the PCBA 601 performs data processing and calls the corresponding program according to the different rotation angles, and the corresponding command is displayed on the display screen assembly 20. Finally, the operator rotates the rotating assembly 10 at different angles to achieve the purpose of inputting different instructions.

The PCBA 601 is located under the pressing assembly 30, and a switch button of the pressing assembly 30 is electrically connected to the PCBA 601. When the pressing assembly 30 is descended by an external force, the switch button is turned on, and the command on the display screen assembly 20 is determined. Since the operator can complete the action of pressing the pressing assembly 30 by manipulating the rotating assembly 10, when operating the washing machine, the operator achieves the command selection by only rotating the rotating assembly 10, and confirms execution of the command by pressing the rotating assembly 10 (namely, pressing the pressing assembly 30).

The rotating assembly 10 includes a knob rotation base 102, a fixed body 104, and a knob decoration ring 101 mounted above the top of the knob rotation base 102. The knob rotation base 102 is provided with a first accommodating groove 102-1 at an upper end thereof, a second accommodating groove 102-2 in a middle section thereof, and a third accommodating groove 102-3 at a lower end thereof. Several uniformly distributed concave-convex grooves 102-4, formed in a gear-shaped structure, are provided on an inner peripheral wall of the second accommodating groove 102-2. The concave-convex grooves 102-4 are arranged in corresponding to a rotating sound generator 50. When the knob rotation base 102 and the rotating sound generator 50 fixed on the knob fixing support 301 move relative to each other, a steel ball 502 of the rotating sound generator 50 rolls along the concave-convex grooves 102-4, namely, moves toward outside or inside alternately, and contacts with the concave-convex inner wall of the second accommodating groove, thereby emitting a warning sound of "tick-tick". For example, an outer end part of the steel ball 502 first enters the concave part of the concave-convex groove 102-4 where the spring 501 is in the original length or compressed state. Then, the steel ball 502 enters the convex part of the concave-convex groove 102-4. The convex part applies a force directed toward the spring 501 to the steel ball 502 to cause the steel ball 502 and the spring 501 to be squeezed. When the steel ball 502 enters the next concave part of the concave-convex groove 102-4, the steel ball 502 will move towards outside under the elastic force of the spring 501. The knob decoration ring 101 and the knob rotation base 102 are fixedly connected, and rotate together around the center line of the knob rotation base 102 as the rotation axis. The fixed body 104 cannot rotate along with the knob rotation base 102.

A metal conductive sheet A103 is mounted at the bottom of the second accommodating groove 102-2. A metal conductive sheet B104-B, a metal conductive sheet C104-C, and a metal conductive sheet D104-D are mounted at the lower end of the fixed body 104. The metal conductive sheet B104-B, the metal conductive sheet C104-C, and the metal conductive sheet D104-D are injected together with the fixed body 104. The metal conductive sheet A103 is provided with a plurality of contacts Z, which are distributed at a certain angle on the metal conductive sheet A103. Pins of the metal conductive sheet B104-B, the metal conductive sheet C104-C, and the metal conductive sheet D104-D are each electrically connected to the PCBA 601. The metal conductive sheet B104-B, the metal conductive sheet C104-C, and the metal conductive sheet D104-D are each provided with a contact pin 104-1 located outside the fixed body, and the contact pins of each metal conductive sheet are arranged according to a certain rule. The metal conductive sheet A can rotate along with the knob rotation base. During rotation, the contacts Z on the metal conductive sheet A contact the corresponding contact pins of the metal conductive sheet B, the metal conductive sheet C, and the metal conductive sheet D exposed outside of the fixed body, forming the function of an incremental encoder, so as to transmit the rotation signal to the PCBA 601, whereby different programs can be selected.

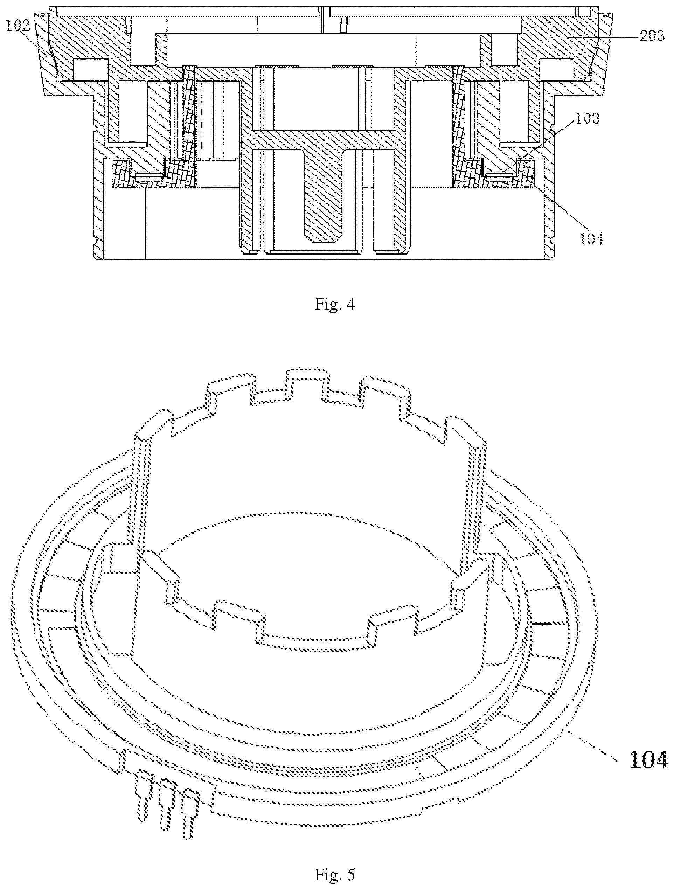

The display screen assembly 20 includes a display base 203, a display module 202 mounted on the top of the display base 203 and electrically connected to the PCBA 601, and a glass lens 201 pasted on the top of the display module 202 by optical glue. As shown in FIG. 4, the upper end of the display base 203 is placed in the first accommodating groove 102-1; the lower end of the fixed body 104 is located below the bottom of the second accommodating groove 102-2, and the upper-middle end of the fixed body 104 passes through the second accommodating groove 102-2 and fixedly connected to the upper end of the display base 203.

The pressing assembly 30 includes a knob fixing support 301, the switch button 302, and the rotating sound generator 50; the knob fixing support 301 includes a supporting plate 301-1, a first supporting groove 301-2 mounted in the upper-middle of the supporting plate 301-1, a second supporting groove 301-3 mounted above the outer periphery of the supporting plate 301-1, and a third supporting groove 301-4 mounted below the supporting plate 301-1; the switch button 302 is mounted in the first supporting groove 301-2 and electrically connected to the PCBA 601; the PCBA 601 is mounted in the third supporting groove 301-4; the supporting plate 301-1 is further provided thereabove with a mounting base for the rotating sound generator and several positioning columns Y; the mounting base for the sound generator is arranged along the outer periphery of the first supporting groove 301-2; the positioning columns Y are located between the first supporting groove 301-2 and the second supporting groove 301-3; a return spring 305 is sleeved on the positioning column Y; the rotating sound generator 50 includes the steel ball 502 and the spring 501; the mounting base for the rotating sound generator is provided with a mounting groove in which the steel ball 502 and the spring 501 are mounted sequentially from outside to inside; the spring 501 has an inner end that is in contact with an outer peripheral wall of the first supporting groove 301-2 and an outer end that is in contact with the steel ball 502; and the outer end part of the steel ball protrudes from an outer opening of the mounting groove and adapts to the concave-convex groove 102-4; the lower-middle end of the knob rotation base 102 is embedded in the second supporting groove 301-3; the middle-lower end of the display base 203 passes through the second accommodating groove 102-2 and extends into the first supporting groove 302-2 to be connected therewith. When the knob structure 1-3 is pressed, the display screen assembly 20 and the fixed body 104 can move downward along the axial direction of the knob structure 1-3, and then contact the switch button 302, whereby the switch button 302 sends a corresponding signal to the PCBA 601. After the pressing action is over, the display screen assembly 20 and the fixed body 104 return to their original positions under the elastic force of the return spring 305.

Further, the knob structure 1-3 further includes a waterproof assembly 40; the waterproof assembly 40 includes a sealing ring A401 disposed between the display base 203 and the first accommodating groove 102-1, a sealing ring B402 disposed between the first accommodating groove 102-1 and the second supporting groove 302-3, a bottom cover 404 mounted at the bottom opening of the third supporting groove 302-4, and a sealing ring C403 disposed between the third supporting groove 302-4 and the bottom cover 404. The sealing ring A401, the sealing ring B402, the sealing ring C403, and the bottom cover 404 all play a sealing function. The waterproof assembly 40 can prevent moisture or water droplets from entering the interior of the knob structure 1-3, and ensure the stability of the working environment of the knob structure 1-3.

Further, the first supporting groove 302-2 is provided with a claw KZ and a guide groove DXC. The claw KZ is used for snap-fit connection with the lower end of the display base 203 to fix the display base 203. A protrusion corresponding to the guide groove DXC is provided on the outer peripheral wall of the lower end of the display base 203, and the protrusion is mounted in the guide groove DXC. The guide groove DXC is used to restrict the display base 203 to move up and down only along the axial direction of the knob structure 1-3.

Further, a gap is formed between the knob decoration ring 101 and the display screen assembly 20, and the gap ensures the display screen assembly 20 to move up and down along the axial direction of the knob structure 1-3 only.

Further, a cover plate 503 is provided above the mounting groove. The cover plate 503 presses the steel ball 502 and the spring 501 into the mounting groove. The size of the mounting groove is designed according to the size of the steel ball 502, so that the steel ball 502 can move in the mounting groove without falling out of the mounting groove.

Further, a silica gel switch 303 is mounted on the switch button 302; a switch bracket 304 for fixing the switch button 302 and the silica gel switch 303 is further mounted on the supporting plate 302-1. The switch button 302 is capable of sensing the pressing signal and transmits the pressing signal to the PCBA 601.

The present invention also relates to a washing machine 1, including a control panel 1-1 that is provided with a touch screen 1-4 at the front thereof and a touch display control system 1-2 at the back thereof, the control panel 1-1 being further provided with the knob structure 1-3 described above; the touch display control system 1-2 being electrically connected to the PCBA 601. The control panel 1-1 is made of transparent materials such as glass, Acrylic, ABS plastics, and stick plastic injection. The front of the entire control panel 1-1 is a touch display area. Information displayed by the touch display control system 1-2 and the display screen assembly 20 can be shared in real time. The control panel 1-1, the touch display control system 1-2, the knob structure 1-3, and the touch screen 1-4 are all installed on the washing machine 1. The program can be selected by the touch display control system 1-1 and the knob structure 1-3, so as to control the operation of the washing machine 1. The touch display control system 1-2 and the knob structure 1-3 are electrically connected. The content displayed by the display screen assembly 20 and the content displayed on the touch screen 1-4 are shared in real time, and more detailed display instructions are displayed on the touch screen 1-4.

## Claims

1. A knob structure (1-3) for a washing machine, comprising a rotating assembly (10), a display screen assembly (20), a pressing assembly (30), an incremental code plate, and a PCBA (601), i.e. a printed circuit board assembly, wherein
the rotating assembly (10) is adapted to transmit a pressing force to the pressing assembly (30), the rotating assembly (10) comprises a knob rotation base (102), a fixed body (104), and a knob decoration ring (101) mounted above the top of the knob rotation base (102); a first accommodating groove (102-1) is provided at an upper end of the knob rotation base (102), a second accommodating groove (102-2) is provided in a middle section of the knob rotation base (102), and a third accommodating groove (102-3) is provided at a lower end of the knob rotation base (102); and a plurality of uniformly distributed concave-convex grooves are provided on an inner peripheral wall of the second accommodating groove (102-2);
the incremental code plate is arranged inside the rotating assembly (10), the incremental code plate is electrically connected to the PCBA (601), and the incremental code plate feed is adapted to back different electrical signals to the PCBA (601) according to a change in the rotation angle of the rotating assembly (10), and the PCBA (601) is adapted to process the electrical signal, then call a corresponding program and send a corresponding command to the display screen assembly (20); and
the display screen assembly (20) is arranged in the rotating assembly (10), the display screen assembly (20) is electrically connected to the PCBA (601), and the display screen assembly (20) is adapted to display various commands of the washing machine, the display screen assembly (20) comprises a display base (203), a display module (202) mounted on a top of the display base (203) and electrically connected to the PCBA (601), and a glass lens (201) pasted on a top of the display module (202); an upper end of the display base (203) is placed in the first accommodating groove (102-1);
**characterized in that**
a lower end of the fixed body (104) is located below a bottom of the second accommodating groove (102-2), an upper-middle end of the fixed body (104) passes through the second accommodating groove (102-2) and is fixedly connected to the upper end of the display base (203); and a gap is formed between the knob decoration ring (101) and the display screen assembly (20);
the PCBA (601) is located under the pressing assembly (30), a switch button (302) of the pressing assembly (30) is electrically connected to the PCBA (601), and when the pressing assembly (30) is descended by an external force, the switch button (302) is adapted to be turned on and the PCBA is adapted to call the command on the display screen assembly (20);
and **in that** the pressing assembly (30) comprises a knob fixing support (301) and the switch button (302); the knob fixing support (301) comprises a supporting plate (301-1), a first supporting groove (301-2) mounted above a middle of the supporting plate (301-1), a second supporting groove (301-3) mounted above an outer periphery of the supporting plate (301-1), and a third supporting groove (301-4) mounted below the supporting plate (301-1); the switch button (302) is mounted in the first supporting groove (301-2) and the switch button (302) is electrically connected to the PCBA (601); the PCBA (601) is mounted in the third supporting groove (301-4); a mounting seat for a rotating sound generator (50) and a plurality of positioning columns are provided above the supporting plate (301-1);
the plurality of positioning columns are located between the first supporting groove (301-2) and the second supporting groove (301-3); a return spring (305) is sleeved on the positioning column; a middle-lower end of the knob rotation base (102) is embedded in the second supporting groove (301-3); a middle-lower end of the display base (203) passes through the second accommodating groove (102-2), and extends into the first supporting groove (301-2) to be connected with the first supporting groove (301-2).

2. The knob structure (1-3) for a washing machine according to claim 1, **characterized in that** the knob structure (1-3) further comprises a waterproof assembly (40); and the waterproof assembly (40) comprises a sealing ring A (401) disposed between the display base (203) and the first accommodating groove (102-1), a sealing ring B (402) disposed between the first accommodating groove (102-1) and the second supporting groove (301-3), a bottom cover (404) mounted at a bottom opening of the third supporting groove (301-4), and a sealing ring C (403) disposed between the third supporting groove (301-4) and the bottom cover (404).

3. The knob structure (1-3) for a washing machine according to claim 2, **characterized in that** the first supporting groove (301-2) is provided with a claw and a guide groove.

4. The knob structure (1-3) for a washing machine according to claim 3, **characterized in that** the knob structure (1-3) further comprises the rotating sound generator (50), wherein a mounting seat for the rotating sound generator (50) is arranged along an outer periphery of the first supporting groove (301-2); the rotating sound generator (50) comprises a steel ball (502) and a spring (501); the mounting base for the rotating sound generator (50) is provided with a mounting groove, wherein a cover plate (503) is disposed on the mounting groove, and the steel ball (502) and the spring (501) are mounted in the mounting groove sequentially from an outside to an inside; the spring (501) has an inner end that is in contact with an outer peripheral wall of the first supporting groove (301-2) and an outer end that is in contact with the steel ball (502); and an outer end part of the steel ball (502) protrudes from an outer opening of the mounting groove then adapts to the concave-convex grooves.

5. The knob structure (1-3) for a washing machine according to claim 4, **characterized in that** the incremental encoder comprises a metal conductive sheet A (103), a metal conductive sheet B (104-B), a metal conductive sheet C (104-C), and a metal conductive sheet D (104-D); wherein, the metal conductive sheet A (103) is mounted at the bottom of the second accommodating groove (102-2); the metal conductive sheet B (104-B), the metal conductive sheet C (104-C), and the metal conductive sheet D (104-D) are mounted at the lower end of the fixed body (104); a plurality of contacts (103-Z) are uniformly arranged on the periphery of the upper end surface of the metal conductive sheet A (103) at a certain angle; pins of the metal conductive sheet B (104-B), the metal conductive sheet C (104-C), and the metal conductive sheet D (104-D) are electrically connected to the PCBA (601); and the metal conductive sheet B (104-B), the metal conductive sheet C (104-C), and the metal conductive sheet D (104-D) are each provided with a contact pin (104-1) located outside the fixed body (104).

6. The knob structure (1-3) for a washing machine according to claim 5, **characterized in that** a silica gel switch (303) is mounted on the switch button (302); and a switch bracket (304) for fixing the switch button (302) and the silica gel switch (303) is further mounted on the supporting plate (301-1).

7. A washing machine, comprising a control panel (1-1), **characterized in that** a touch screen (1-4) is provided at the front of the control panel (1-1), a touch display control system (1-2) is provided at the back of the control panel (1-1), and the knob structure (1-3) according to any one of claims 1-6 is provided at the control panel; the touch display control system (1-2) is electrically connected to the PCBA (601).

## Patentansprüche

1. Die Drehknopf-Struktur (1-3) für eine Waschmaschine, die eine Dreheinheit (10), eine Bildschirmeinheit (20), eine Druckeinheit (30), eine inkrementelle Codeplatte und eine PCBA (601), d.h. eine gedruckte Platine-Einheit, umfasst, wobei:
die Dreheinheit (10) geeignet ist, eine Druckkraft auf die Druckeinheit (30) zu übertragen, die Dreheinheit (10) eine Drehknopf-Basis (102), ein festen Gehäuse (104) und einen Drehknopf-Zierring (101) umfasst, der über der Oberseite der Drehknopf-Basis (102) angebracht ist: eine erste Aufnahmerille (102-1) an einem oberen Ende der Drehknopf-Basis (102) vorgesehen ist, eine zweite Aufnahmerille (102-2) in einem mittleren Abschnitt der Drehknopf-Basis (102) vorgesehen ist, und eine dritte Aufnahmerille (102-3) an einem unteren Ende der Drehknopf-Basis (102) vorgesehen ist; und eine Vielzahl von gleichmäßig verteilten konkav-konvexen Rillen an einer inneren Außenwand der zweiten Aufnahmerille (102-2) vorgesehen sind;
die inkrementelle Codeplatte im Inneren der Dreheinheit (10) angeordnet ist, die inkrementelle Codeplatte elektrisch mit der PCBA (601) verbunden ist, und die inkrementelle Codeplattenzuführung angepasst ist, um verschiedene elektrische Signale an die PCBA (601) entsprechend einer Änderung des Drehwinkels der Dreheinheit (10) zurückzusenden, und die PCBA (601) angepasst ist, um das elektrische Signal zu verarbeiten, dann ein entsprechendes Programm aufzurufen und einen entsprechenden Befehl an die Bildschirmeinheit (20) zu senden; und
die Bildschirmeinheit (20) in der Dreheinheit (10) angeordnet ist, die Bildschirmeinheit (20) elektrisch mit der PCBA (601) verbunden ist und die Bildschirmeinheit (20) verschiedene Befehle der Waschmaschine anzeigen kann, die Bildschirmeinheit (20) eine Display-Basis (203), ein auf einer Oberseite der Display-Basis (203) montiertes und elektrisch mit der PCBA (601) verbundenes Display-Modul (202) und eine auf eine Oberseite des Display-Moduls (202) eingefügte Glaslinse (201) umfasst; ein oberes Ende der Display-Basis (203) in der ersten Aufnahmerille (102-1) angeordnet ist;
**dadurch gekennzeichnet, dass**
ein unteres Ende des festen Gehäuses (104) unterhalb eines Bodens der zweiten Aufnahmerille (102-2) angeordnet ist, ein oberes mittleres Ende des festen Gehäuses (104) durch die zweite Aufnahmerille (102-2) hindurchgeht und fest mit dem oberen Ende der Display-Basis (203) verbunden ist; und ein Spalt zwischen dem Drehknopf-Zierring (101) und der Bildschirmeinheit (20) gebildet ist;
die PCBA (601) unter der Druckeinheit (30) angeordnet ist, ein Schaltknopf (302) der Druckeinheit (30) elektrisch mit der PCBA (601) verbunden ist und, wenn die Druckeinheit (30) durch eine äußere Kraft abgesenkt wird, der Schaltknopf (302) so angepasst ist, dass er eingeschaltet wird und die PCBA so angepasst ist, dass sie den Befehl auf der Bildschirmeinheit (20) aufruft;
und wobei die Druckeinheit (30) einen Drehknopf-Befestigungsträger (301) und den Schaltknopf (302) umfasst: der Drehknopf-Befestigungsträger (301) umfasst eine Stützplatte (301-1), eine erste Stützrille (301-2), die oberhalb eines Mittelteils der Stützplatte (301-1) angebracht ist, eine zweite Stützrille (301-3), die oberhalb eines Außenrands der Stützplatte (301-1) angebracht ist, und eine dritte Stützrille (301-4), die unterhalb der Stützplatte (301-1) angebracht ist: der Schaltknopf (302) ist in der ersten Stützrille (301-2) montiert und der Schaltknopf (302) ist elektrisch mit der PCBA (601) verbunden; die PCBA (601) ist in der dritten Stützrille (301-4) montiert;
ein Montagesitz für einen drehenden Tongenerator (50) und eine Vielzahl von Stellsäulen sind oberhalb der Stützplatte (301-1) vorgesehen;
die mehreren Stellsäulen zwischen der ersten Stützrille (301-2) und der zweiten Stützrille (301-3) angeordnet sind; eine Rückstellfeder (305) auf die Stellsäule aufgeschoben ist; ein mittleres unteres Ende der Drehknopf-Basis (102) in die zweite Stützrille (301-3) eingebettet ist; ein mittleres unteres Ende der Display-Basis (203) durch die zweite Aufnahmerille (102-2) hindurchgeht und sich in die erste Stützrille (301-2) erstreckt, um mit der ersten Stützrille (301-2) verbunden zu werden.

2. Die Drehknopf-Struktur (1-3) für eine Waschmaschine nach Anspruch 1, **dadurch gekennzeichnet, dass** die Drehknopf-Struktur (1-3) weiterhin eine wasserdichte Anordnung (40) umfasst; und die wasserdichte Baugruppe (40) einen Dichtungsring A (401), der zwischen der Display-Basis (203) und der ersten Aufnahmerille (102-1) angeordnet ist, einen Dichtungsring B (402), der zwischen der ersten Aufnahmerille (102-1) und der zweiten Stützrille (301-3) angeordnet ist, eine untere Abdeckung (404), die an einer unteren Öffnung der dritten Stützrille (301-4) angebracht ist, und einen Dichtungsring C (403) umfasst, der zwischen der dritten Stützrille (301-4) und der unteren Abdeckung (404) angeordnet ist.

3. Die Drehknopf-Struktur (1-3) für eine Waschmaschine nach Anspruch 2, **dadurch gekennzeichnet, dass** die erste Stützrille (301-2) mit einer Klaue und einer Führungsrille versehen ist.

4. Die Drehknopf-Struktur (1-3) für eine Waschmaschine nach Anspruch 3. **dadurch gekennzeichnet, dass** die Drehknopf-Struktur (1-3) ferner den drehenden Tongenerator (50) umfasst, wobei ein Montagesitz für den drehenden Tongenerator (50) entlang eines Außenumfangs der ersten Stützrille (301-2) angeordnet ist: der drehende Tongenerator (50) umfasst eine Stahlkugel (502) und eine Feder (501); der Montagesitz für den drehenden Tongenerator (50) ist mit einer Montagenut versehen, wobei eine Abdeckplatte (503) auf der Montagenut angeordnet ist, und die Stahlkugel (502) und die Feder (501) in der Montagenut nacheinander von außen nach innen montiert sind; die Feder (501) ein inneres Ende hat, das in Kontakt mit einer externen Außenwand der ersten Stützrille (301-2) ist, und ein äußeres Ende, das in Kontakt mit der Stahlkugel (502) ist: und ein äußeres Endteil der Stahlkugel (502) aus einer äußeren Öffnung der Montagenut herausragt und sich dann an die konkav-konvexen Nuten anpasst.

5. Die Drehknopf-Struktur (1-3) für eine Waschmaschine nach Anspruch 4, **dadurch gekennzeichnet, dass** der Inkrementalgeber ein leitfähiges Metallblech A (103), ein leitfähiges Metallblech B (104-B), ein leitfähiges Metallblech C (104-C) und ein leitfähiges Metallblech D (104-D) umfasst, wobei das leitfähige Metallblech A (103) am Boden der zweiten Aufnahmerille (102-2) angebracht ist: das leitfähige Metallblech B (104-B), das leitfähige Metallblech C (104-C) und das leitfähige Metallblech D (104-D) am unteren Ende des festen Gehäuses (104) angebracht sind: eine Vielzahl von Kontakten (103-Z) sind gleichmäßig auf dem Umfang der oberen Endfläche des leitfähigen Metallblechs A (103) in einem bestimmten Winkel angeordnet; Stifte des leitfähigen Metallblechs B (104-B), des leitfähigen Metallblechs C (104-C) und des leitfähigen Metallblechs D (104-D) sind elektrisch mit der PCBA (601) verbunden: und das leitfähige Metallblech B (104-B), das leitfähige Metallblech C (104-C) und das leitfähige Metallblech D (104-D) sind jeweils mit einem Kontaktstift (104-1) versehen, der sich außerhalb des festen Gehäuses (104) befindet.

6. Die Drehknopf-Struktur (1-3) für eine Waschmaschine nach Anspruch 5, **dadurch gekennzeichnet, dass** ein Kieselgel-Schalter (303) auf dem Schaltknopf (302) angebracht ist; und eine Schalter-Halterung (304) zum Befestigen des Schaltknopfes (302) und des Kieselgel-Schalters (303) weiterhin auf der Stützplatte (301-1) angebracht ist.

7. Eine Waschmaschine mit einem Bedienfeld (1-1), **dadurch gekennzeichnet, dass** ein Touchscreen (1-4) an der Vorderseite des Bedienfeldes (1-1) vorgesehen ist, ein Touch-Display-Steuersystem (1-2) an der Rückseite des Bedienfeldes (1-1) vorgesehen ist und die Drehknopf-Struktur (1-3) gemäß einem der Ansprüche 1-6 an dem Bedienfeld vorgesehen ist: das Touch-Display-Steuersystem (1-2) ist elektrisch mit der PCBA (601) verbunden.

## Revendications

1. Une structure du bouton (1-3) pour une machine à laver, comprenant un ensemble rotatif (10), un ensemble d'écran d'affichage (20), un ensemble de pressage (30), une plaque de code incrémentielle et un PCBA (601), c'est-à-dire un ensemble de carte de circuit imprimé, dans lequel :
l'ensemble rotatif (10) est adapté pour transmettre une force de pression à l'ensemble de pressage (30), l'ensemble rotatif (10) comprend une base de rotation du bouton (102), un corps fixe (104), et un anneau de décoration du bouton (101) monté au-dessus du sommet de la base de rotation du bouton (102) : une première rainure de logement (102-1) est prévue à une extrémité supérieure de la base de rotation du bouton (102), une deuxième rainure de logement (102-2) est prévue dans une section centrale de la base de rotation du bouton (102), et une troisième rainure de logement (102-3) est prévue à une extrémité inférieure de la base de rotation du bouton (102) :
et une pluralité de rainures concaves-convexes uniformément réparties sont prévues sur une paroi périphérique intérieure de la deuxième rainure de logement (102-2) ;
la plaque de code incrémentielle est disposée à l'intérieur de l'ensemble rotatif (10), la plaque de code incrémentielle est connectée électriquement au PCBA (601), et l'alimentation de la plaque de code incrémentielle est adaptée pour renvoyer différents signaux électriques au PCBA (601) en fonction d'un changement de l'angle de rotation de l'ensemble rotatif (10), et le PCBA (601) est adapté pour traiter le signal électrique, puis appeler un programme correspondant et envoyer une commande correspondante à l'ensemble d'écran d'affichage (20) ; et
l'ensemble d'écran d'affichage (20) est disposé dans l'ensemble rotatif (10), l'ensemble d'écran d'affichage (20) est connecté électriquement au PCBA (601), et l'ensemble d'écran d'affichage (20) est adapté pour afficher diverses commandes du lave-linge, l'ensemble d'écran d'affichage (20) comprend une base d'affichage (203), un module d'affichage (202) monté sur un sommet de la base d'affichage (203) et connecté électriquement au PCBA (601), et une lentille en verre (201) collée sur un sommet du module d'affichage (202) ; une extrémité supérieure de la base d'affichage (203) est placée dans la première rainure de logement (102-1) ;
**caractérisé par le fait**
**qu'**une extrémité inférieure du corps fixe (104) est située sous le fond de la deuxième rainure de logement (102-2), une extrémité médiane supérieure du corps fixe (104) traverse la deuxième rainure de logement (102-2) et est reliée de manière fixe à l'extrémité supérieure de la base d'affichage (203) ; et un espace est formé entre l'anneau de décoration du bouton (101) et l'ensemble d'écran d'affichage (20) ;
le PCBA (601) est situé sous l'ensemble de pressage (30), un bouton de commutation (302) de l'ensemble de pressage (30) est connecté électriquement au PCBA (601), et lorsque l'ensemble de pressage (30) est descendu par une force extérieure, le bouton de commutation (302) est adapté pour être activé et le circuit imprimé est adapté pour appeler la commande sur l'ensemble d'écran d'affichage (20) ;
et en ce que l'ensemble de pressage (30) comprend un support de fixation du bouton (301) et le bouton de commutation (302) : le support de fixation du bouton (301) comprend une plaque de support (301-1), une première rainure de support (301-2) montée au-dessus d'un milieu de la plaque de support (301-1), une deuxième rainure de support (301-3) montée au-dessus d'une périphérie extérieure de la plaque de support (301-1), et une troisième rainure de support (301-4) montée en dessous de la plaque de support (301-1) : le bouton de commutation (302) est monté dans la première rainure de support (301-2) et le bouton de commutation (302) est connecté électriquement au PCBA (601) : le PCBA (601) est monté dans la troisième rainure de support (301-4) : un siège de montage pour un générateur de son rotatif (50) et une pluralité de colonnes de positionnement sont prévus au-dessus de la plaque de support (301-1) ;
la pluralité de colonnes de positionnement est située entre la première rainure de support (301-2) et la deuxième rainure de support (301-3) : un ressort de rappel (305) est manchonné sur la colonne de positionnement ; une extrémité moyenne inférieure de la base de rotation du bouton (102) est encastrée dans la deuxième rainure de support (301-3) : une extrémité moyenne inférieure de la base d'affichage (203) traverse la deuxième rainure de logement (102-2) et s'étend dans la première rainure de support (301-2) pour être reliée à la première rainure de support (301-2).

2. La structure du bouton (1-3) pour un lave-linge selon la revendication 1, **caractérisée en ce que** la structure du bouton (1-3) comprend en outre un ensemble étanche (40) ; et l'ensemble étanche (40) comprend un joint d'étanchéité A (401) disposé entre la base d'affichage (203) et la première rainure de logement (102-1), un joint d'étanchéité B (402) disposé entre la première rainure de logement (102-1) et la deuxième rainure de support (301-3), un couvercle inférieur (404) monté sur une ouverture inférieure de la troisième rainure de support (301-4), et un joint d'étanchéité C (403) disposé entre la troisième rainure de support (301-4) et le couvercle inférieur (404).

3. La structure du bouton (1-3) pour machine à laver selon la revendication 2, **caractérisée par le fait que** la première rainure de support (301-2) est pourvue d'une griffe et d'une rainure de guidage.

4. La structure du bouton (1-3) pour une machine à laver selon la revendication 3. **Caractérisée par le fait que** la structure du bouton (1-3) comprend en outre le générateur de son rotatif (50), dans lequel un siège de montage pour le générateur de son rotatif (50) est disposé le long d'une périphérie extérieure de la première rainure de support (301-2) : le générateur de son rotatif (50) comprend une bille d'acier (502) et un ressort (501) ; la base de montage du générateur de son rotatif (50) est pourvue d'une rainure de montage, dans laquelle une plaque de recouvrement (503) est disposée sur la rainure de montage, et la bille d'acier (502) et le ressort (501) sont montés dans la rainure de montage de manière séquentielle, de l'extérieur vers l'intérieur ; le ressort (501) a une extrémité intérieure qui est en contact avec une paroi périphérique extérieure de la première rainure de support (301-2) et une extrémité extérieure qui est en contact avec la bille d'acier (502) : et une partie de l'extrémité extérieure de la bille d'acier (502) dépasse d'une ouverture extérieure de la rainure de montage et s'adapte aux rainures concaves-convexes.

5. La structure du bouton (1-3) pour machine à laver selon la revendication 4, **caractérisée en ce que** le codeur incrémental comprend une feuille conductrice métallique A (103), une feuille conductrice métallique B (104-B), une feuille conductrice métallique C (104-C), et une feuille conductrice métallique D (104-D) ; dans laquelle, la feuille conductrice métallique A (103) est montée au fond de la deuxième rainure de logement (102-2) : la feuille conductrice métallique B (104-B), la feuille conductrice métallique C (104-C) et la feuille conductrice métallique D (104-D) sont montées à l'extrémité inférieure du corps fixe (104) : plusieurs contacts (103-Z) sont disposés uniformément sur la périphérie de la surface d'extrémité supérieure de la feuille conductrice métallique A (103) selon un certain angle ; les broches de la feuille conductrice métallique B (104-B), de la feuille conductrice métallique C (104-C) et de la feuille conductrice métallique D (104-D) sont connectées électriquement à la carte à PCBA (601) : et la feuille conductrice métallique B (104-B), la feuille conductrice métallique C (104-C), et la feuille conductrice métallique D (104-D) sont chacune pourvues d'une goupille de contact (104-1) située à l'extérieur du corps fixe (104).

6. La structure du bouton (1-3) pour une machine à laver selon la revendication 5, **caractérisée par le fait qu'**un interrupteur à gel de silice (303) est monté sur le bouton de commutation (302) : et un support d'interrupteur (304) pour fixer le bouton de commutation (302) et l'interrupteur à gel de silice (303) est également monté sur la plaque de support (301-1).

7. Lave-linge comprenant un panneau de commande (1-1), **caractérisé par le fait qu'**un écran tactile (1-4) est placé à l'avant du panneau de commande (1-1), qu'un système de commande à écran tactile (1-2) est placé à l'arrière du panneau de commande (l-1) et que la structure à boutons (1-3) selon l'une quelconque des revendications 1 à 6, placée sur le panneau de commande : le système de commande à écran tactile (1-2) est connecté électriquement au PCBA (601).
